# EUROPÄISCHE PATENTSCHRIFT

(11) **EP 1 266 547 B1**
(45) Veröffentlichungstag und Bekanntmachung des Hinweises auf die Patenterteilung: **01.12.2004**
(21) Anmeldenummer: 01916921.8
(22) Anmeldetag: 13.03.2001
(51) Int. Cl.: H05K 5/06, H05K 5/02

(54) **GEHÄUSE FÜR EIN ELEKTRISCHES GERÄT**
HOUSING FOR AN ELECTRIC DEVICE
BOITIER POUR APPAREIL ELECTRIQUE

(30) Priorität: 14.03.2000 DE 10012297
(43) Veröffentlichungstag der Anmeldung: 18.12.2002
(73) Patentinhaber: ROBERT BOSCH GMBH, 70442 Stuttgart (DE)
(72) Erfinder: BECKBISSINGER, Kai, 70569 Stuttgart (DE); EISERMANN, Günter, 80757 Karlsfeld (DE); KALASS, Rainer, 91189 Rohr (DE); SIMON, Ewald, 91207 Lauf (DE)
(86) Internationale Anmeldenummer: PCT/DE2001/000935
(87) Internationale Veröffentlichungsnummer: WO 2001/069993

(56) Entgegenhaltungen:
- DE-U- 29 901 601
- US-A- 4 600 114
- US-A- 4 980 707

## Beschreibung

### Stand der Technik

Die Erfindung betrifft ein Gehäuse für ein elektrisches Gerät nach der Gattung des Hauptanspruchs.

In der Regel werden elektrische und elektronische Bauelemente, insbesondere elektronische Steuergeräte in Kraftfahrzeugen, zum Schutz vor äußeren Einflüssen in relativ dichte Gehäuse eingebaut. Vor allem müssen derartige Gehäuse die elektronischen Bauelemente, die Leiterplatten und sonstige Schaltungsmittel vor flüssigen und ev. auch aggressiven Medien schützen, die in das Gehäuse eindringen können.

Für sich gesehen ist es üblich, dass derartige Gehäuse mit Elementen zum Druckausgleich versehen werden. Hiermit kann ein Druckausgleich zwischen dem Gehäuseinnendruck und dem Atmosphärendruck stattfinden, um so ein Eindringen von flüssigen Medien in das Gehäuseinnere zu verhindern. Um an diesen Druckausgleichselementen selbst ein Eindringen von flüssigen Medien zu verhindern, ist es zusätzlich üblich, dass diese auch mit einer wasserdichten und atmungsaktiven Folie verschlossen werden können, so dass die elektrischen oder elektronischen Bauelemente vor dem Eindringen von flüssigen Medien bewahrt werden.

Nachteilig ist bei diesen Anordnungen jedoch, dass ab einem bestimmten Differenzdruck, bzw. Berstdruck, zwischen dem Gehäuseinneren und der Umgebung sowie einem gleichzeitigen Anliegen eines flüssigen Mediums am Druckausgleichselement, dieses Medium durch das Druckausgleichselement dringen kann und dies somit zu einer Schädigung der elektrischen oder elektronischen Bauelemente führt. Weiter kann auch der im Gehäuseinneren entstehende Unterdruck dazu führen, dass durch eventuelle Mikrolecks an Gehäuseteilen und Dichtstellen flüssige Medien in das Gehäuseinnere eindringen.

### Vorteile der Erfindung

Ein Gehäuse für ein elektrisches Gerät der eingangs erwähnten Art, bei der das Gehäuse elektrische oder elektronische Bauelemente enthält und in ein flüssiges Medium eintauchbar ist, wird mit den sonstigen Merkmalen des Hauptanspruch in vorteilhafter Weise weitergebildet. Am Gehäuse ist ein Druckausgleichselement vorhanden, mit dem ein Ausgleich des Innendrucks im Gehäuse mit dem außen anstehenden Druck herbeiführbar ist und die Zuführung des Außendrucks auf das Druckausgleichselement erfolgt. In vorteilhafter Weise erfolgt dies über eine Tauchglocke, die ebenfalls in das flüssige Medium eintaucht und deren eingeschlossenes Luftvolumen mit der Außenseite des Druckausgleichselements in Wirkverbindung steht.

Somit ist es möglich, dass bei einem Gehäuse der zuvor genannten Art zum einen ein Druckausgleich ermöglicht ist, zum anderen gleichzeitig die elektrischen bzw. elektronischen Bauelemente zuverlässig vor dem Eindringen von flüssigen Medien geschützt sind und somit nicht überflutet werden können. Der Grundgedanke ist hierbei, dass das Anstehen von flüssigen Medien am Druckausgleichselement bei Druckdifferenzen zwischen dem Gehäuseinneren und der Umgebung überhaupt verhindert wird.

Das Luftvolumen in der Tauchglocke ist erfindungsgemäß so bemessen, dass dieses größer ist als das Luftvolumen, das bei einer vorgegebenen Temperaturverringerung in das Gehäuse nachzuführen ist. Bei einer bevorzugten Ausführungsform ist die Tauchglocke auf einfache Weise über eine Schlauchverbindung flexibel mit einem am Druckausgleichselement befindlichen Anschlussadapter verbunden, wobei in besonders vorteilhafter Weise die Schlauchverbindung über eine Ringdichtung abgedichtet, drehbar gehalten ist.

Weiterhin kann auf einfache Weise der Anschlussadapter über eine weitere Dichtung und mittels Befestigungselementen am Gehäuse, unter Einschluss des Druckausgleichselements, gehalten werden. Zusätzlich kann auch hier im Gehäuseinneren der Atmosphärendruck elektronisch erfasst und diese Messgröße, zum Beispiel bei einer Anwendung im Kraftfahrzeug, der Motorsteuerung zur Verfügung gestellt werden.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ein Ausführungsbeispiel des erfindungsgemäßen Gehäuses für ein elektrisches Gerät wird anhand der Zeichnung erläutert. Es zeigen:
Figur 1 eine Ansicht eines in ein flüssiges Medium eintauchbares Gehäuses für ein elektronisches Steuergerät mit einem Druckausgleichselement und einer daran angeschlossenen Tauchglocke und
Figur 2 eine Detailansicht des Druckausgleichselements nach der Figur 1.

### Beschreibung des Ausführungsbeispiels

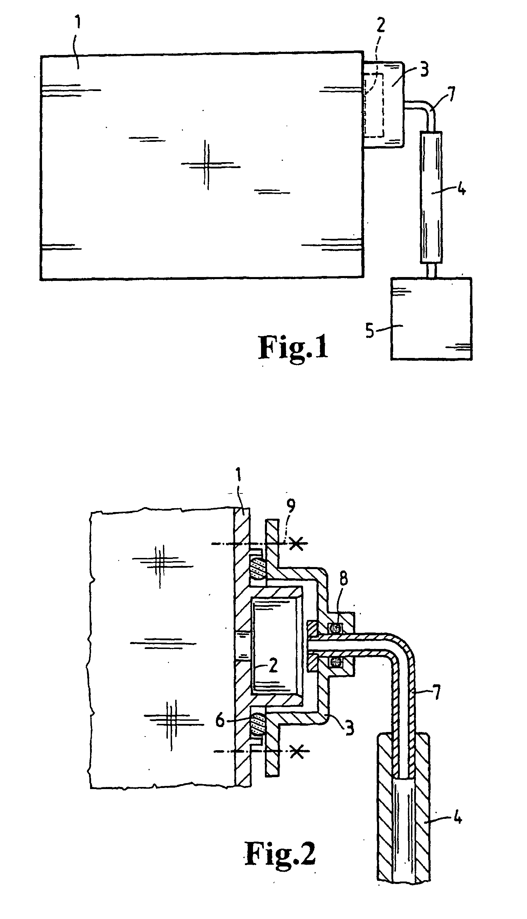

In Figur 1 ist ein Gehäuse 1 für ein elektronisches Steuergerät gezeigt, das mit einem Druckausgleichselement 2 versehen ist. Am Druckausgleichselement 2 befindet sich ein Anschlussadapter 3 für eine Schlauchverbindung 4 zu einer Tauchglocke 5.

Das Druckausgleichselement 2 ist im Detail auch aus der Darstellung nach Figur 2 zu erkennen. Hieraus ist ferner zu entnehmen, dass der Anschlussadapter 3 über eine Dichtung 6 am Gehäuse 1 anliegt und die Schlauchverbindung 4 mit einem Schlauchanschluss 7 drehbar über einen Dichtungsring 8 am Anschlussadapter 3 gehalten ist. Der Anschlussadapter 3 ist mittels einer oder mehrerer Schraubverbindungen 9 am Gehäuse 1 befestigt.

Die insbesondere aus der Figur 1 zu entnehmende Tauchglocke 5 ist somit über die Schlauchverbindung 4 am Druckausgleichselement 2 dicht adaptiert. Durch geeignete Abmessungen ist das in der Tauchglocke 5 eingeschlossene Luftvolumen hier größer gewählt als das im Inneren des Gehäuses 1 befindliche Luftvolumen, das bei einer Abkühlung des Gehäuses 1 nachgeführt werden muss, um die Druckdifferenz zwischen dem Gehäuseinneren und der Umgebung auszugleichen.

Wenn dieses Abkühlen durch ein Eintauchen des Gehäuses 1 in ein flüssiges Medium, zum Beispiel bei einer Anwendung als Steuergerät im Kraftfahrzeug, erfolgt, wird durch die Tauchglocke 5 verhindert, daß das flüssige Medium direkt am Druckausgleichselement 2 zum Anstehen kommt. Dadurch wird ein Druckausgleich zwischen dem Inneren des Gehäuses 1 und der Umgebung gewährleistet und ein Eindringen des flüssigen Mediums verhindert.

## Patentansprüche

1. Gehäuse für ein elektrisches Gerät,
- das elektrische oder elektronische Bauelemente enthält und das in ein flüssiges Medium eintauchbar ist, wobei
- am Gehäuse (1) ein Druckausgleichselement (2) vorhanden ist, mit dem ein Ausgleich des Innendrucks im Gehäuse (1) mit dem außen anstehenden Druck herbeiführbar ist und
- die Zuführung des Außendrucks auf das Druckausgleichselement (2) über eine Tauchglocke (5) erfolgt, die ebenfalls im flüssigen Medium eintaucht und deren eingeschlossenes Luftvolumen mit der Außenseite des Druckausgleichselements (2) in Wirkverbindung steht.

2. Gehäuse nach Anspruch 1, **dadurch gekennzeichnet, dass**
- das Luftvolumen in der Tauchglocke (5) so bemessen ist, dass dieses größer ist als das Luftvolumen, das bei einer vorgegebenen Temperaturverringerung in das Gehäuse (1) nachzuführen ist.

3. Gehäuse nach Anspruch 1 oder 2, **dadurch gekennzeichnet, dass**
- die Tauchglocke (5) über eine Schlauchverbindung (4) flexibel mit einem am Druckausgleichselement (2) befindlichen Anschlussadapter (3) verbunden ist.

4. Gehäuse nach Anspruch 3, **dadurch gekennzeichnet, dass**
- die Schlauchverbindung (4) mit einem Schlauchanschluss (7) drehbar, über einen Dichtungsring (8) abgedichtet, gehalten ist.

5. Gehäuse nach Anspruch 3 oder 4, **dadurch gekennzeichnet, dass**
- der Anschlussadapter (3) über eine Dichtung (6) und mittels einer oder mehrerer Befestigungselemente (9) am Gehäuse (1), unter Einschluss des Druckausgleichselements (2), gehalten ist.

## Claims

1. Housing for an electrical device,
- which contains electrical or electronic components and which can be submersed in a liquid medium,
- the housing (1) having on it a pressure-equalizing element (2), with which an equalization of the pressure inside the housing (1) with the outside pressure can be brought about, and
- the delivery of the outside pressure to the pressure-equalizing element taking place via a submersible bulb (5), which is likewise submersed in the liquid medium and the enclosed air volume of which is in operative connection with the outside of the pressure-equalizing element (2).

2. Housing according to Claim 1, **characterized in that**
- the volume of air in the submersible bulb (5) is dimensioned such that it is greater than the volume of air with which the housing (1) is to be replenished when there is a predetermined reduction in temperature.

3. Housing according to Claim 1 or 2, **characterized in that**
- the submersible bulb (5) is connected flexibly via a hose connection (4) to a connection adapter
(3) located on the pressure-equalizing element (2).

4. Housing according to Claim 3, **characterized in that**
- the hose connection (4) is held rotatably by a hose connector (7), sealed by means of a sealing ring (8).

5. Housing according to Claim 3 or 4, **characterized in that**
- the connection adapter (3) is held on the housing (1) via a seal (6) and by means of one or more fastening elements (9), while enclosing the pressure-equalizing element (2).

## Revendications

1. Boîtier pour appareil électrique,
- qui contient des composants électriques ou électroniques et peut être immergé dans un liquide, et dans lequel
- un élément d'égalisation de pression (2) placé sur le boîtier (1) permet de réaliser une compensation de la pression intérieure dans le boîtier (1) avec la pression existant à l'extérieur, et
- l'amenée de la pression extérieure sur l'élément d'égalisation de pression (2) s'effectue via une cloche à immersion (5) qui est également immergée dans le liquide et dont le volume d'air inclus se trouve en liaison active avec la face extérieure de l'élément d'égalisation de pression (2).

2. Boîtier selon la revendication 1,
**caractérisé en ce que**
le volume d'air dans la cloche à immersion (5) est dimensionné plus grand que le volume d'air devant être restitué dans le boîtier (1) pour une diminution de température prévue.

3. Boîtier selon la revendication 1 ou 2,
**caractérisé en ce que**
la cloche à immersion (5) est reliée de manière souple à un adaptateur de raccord (3) se trouvant sur l'élément d'égalisation de pression (2) via un tuyau de liaison (4).

4. Boîtier selon la revendication 3,
**caractérisé en ce que**
le tuyau de liaison (4) est maintenu solidaire en rotation avec un raccord de tuyau (7) en étant rendu étanche par une bague d'étanchéité (8).

5. Boîtier selon la revendication 3 ou 4,
**caractérisé en ce que**
l'adaptateur de raccord (3) est maintenu sur le boîtier (1) via un joint d'étanchéité (6) et à l'aide d'un ou plusieurs éléments de fixation (9), y compris l'élément d'égalisation de pression.
